# DEMANDE DE BREVET EUROPEEN

(11) **EP 2 320 427 A1**
(43) Date de publication de la demande: **11.05.2011**
(21) Numéro de dépôt: 10188638.0
(22) Date de dépôt: 25.10.2010
(51) Int. Cl.: G11C 16/04, G11C 14/00

(54) **Dispositif de mémoire du type électriquement programmable et effaçable, à deux cellules par bit**

(30) Priorité: 29.10.2009 FR 0957623
(71) Demandeur: STMicroelectronics (Rousset) SAS, 13790 Rousset (FR)
(72) Inventeur: Tailliet, François, 13710 Fuveau (FR)
(74) Mandataire: Zapalowicz, Francis

(57) **Abrégé**

Le dispositif de mémoire comprend au moins un point mémoire (PTM) du type non volatile électriquement programmable et effaçable comportant deux cellules mémoire (CEL1, CEL2) respectivement connectées à deux lignes de bits (BL+, BL-) par l'intermédiaire de deux transistors de sélection de lignes de bits. La borne commune (S1) entre le transistor de sélection de ligne de bit (TSBL1) et le transistor à grille flottante (TGF1) de chaque cellule-mémoire (CEL1) du point-mémoire est connectée à la grille de commande (CG2) du transistor à grille flottante (TGF2) de l'autre cellule-mémoire (CEL2) du point-mémoire.

## Description

L'invention concerne les mémoires, en particulier les mémoires non volatiles de type électriquement effaçable et programmable (EEPROM) à deux cellules par bit.

Dans les mémoires EEPROM, la valeur logique d'un bit stocké dans une cellule-mémoire est représentée par la valeur de la tension de seuil d'un transistor à grille flottante, qui peut être modifiée à volonté par des opérations d'effacement ou de programmation. La programmation ou l'effacement d'un transistor à grille flottante consiste dans l'injection ou l'extraction des charges électriques dans la grille du transistor par effet tunnel (effet « Fowler-Nordheim ») au moyen d'une tension de programmation/effacement Vpp qui peut être de l'ordre de 10 à 20 volts.

Pour lire une telle cellule-mémoire, on compare la tension de seuil du transistor avec une tension de référence qui, en général, se trouve sensiblement à mi-chemin entre la tension de seuil négative d'un transistor programmé et la tension de seuil positive d'un transistor effacé. En pratique, cette comparaison est réalisée en appliquant sur la grille du transistor une tension de lecture sensiblement égale à la tension de référence, puis en observant si le transistor est passant ou bloqué. L'état passant ou bloqué du transistor est détecté par un circuit de lecture communément désigné par l'homme du métier sous la dénomination anglosaxonne de « sense amplifier », connecté à la ligne de bit à laquelle le transistor à grille flottante est lui-même connecté.

Pendant ce processus de lecture, un transistor effacé reste bloqué car sa tension de seuil est supérieure à la tension de lecture. De ce fait, aucun courant ne circule dans la ligne de bit et cela correspond à un premier état logique du bit stocké dans la cellule, par exemple un bit ayant la valeur logique zéro.

Un transistor programmé est au contraire passant car sa tension de seuil est inférieure à la tension de lecture. Dans ce cas, un courant circule dans la ligne de bit et cela correspond par convention à un bit ayant la valeur logique opposée, par exemple la valeur logique 1.

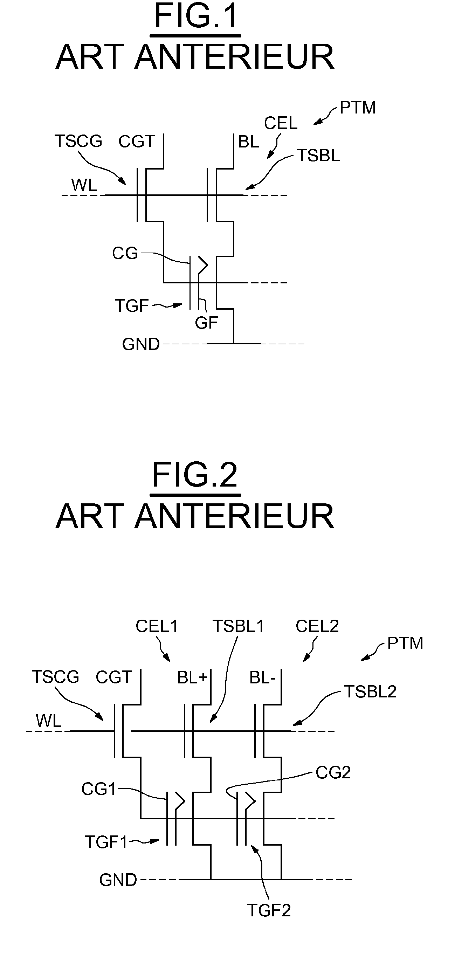

Des architectures classiques de points-mémoire EEPROM sont illustrées sur les figures 1 et 2. ,

Plus précisément, sur la figure 1, le point-mémoire PTM comporte une cellule-mémoire CEL comportant un transistor TGF ayant une grille de commande CG et une grille flottante GF. La cellule CEL est connectée à une ligne de bit BL par l'intermédiaire d'un transistor de sélection de ligne de bit TSBL.

La cellule comporte par ailleurs un transistor de sélection de grille de commande TSCG connecté entre une ligne de commande de grille CGT et la grille de commande CG du transistor à grille flottante TGF.

Les grilles des transistors TSCG et TSBL sont reliées à une ligne de mots WL s'étendant classiquement perpendiculairement à la ligne de bit BL.

L'architecture de la figure 1 prévoit donc une cellule-mémoire par bit.

Pour effacer la cellule, on applique la tension de programmation Vpp sur la ligne de mot WL ainsi que sur la ligne de commande de grille CGT tandis qu'on applique une tension nulle sur la borne GND reliée à la source du transistor TGF et qu'on laisse généralement flottante la ligne de bit BL.

En écriture, on applique la tension de programmation sur la ligne de mot WL tandis qu'on applique une tension nulle sur la ligne CGT. Pour écrire un « 1 » (par exemple) on applique la tension de programmation Vpp sur la ligne de bit BL tandis qu'on laisse cette ligne de bit BL flottante pour l'écriture d'un « 0 ». Dans les deux cas, la borne GND est flottante.

Généralement, on stocke dans la mémoire EEPROM des mots de x bits, typiquement 8 bits, formant dans ce cas des octets. Typiquement, la zone de stockage d'un octet comporte donc huit points-mémoire plus un transistor de sélection de commande de grille TSCG (car généralement, les grilles de commande des huit cellules-mémoire des huit points-mémoire sont toutes connectées ensemble et sélectionnés à partir de la ligne CGT), ainsi qu'une ligne de masse.

Une programmation d'un octet se compose donc d'un cycle d'effacement global pour le mot, suivi d'un cycle d'écriture sélectif.

Afin d'améliorer la fiabilité des points-mémoire, il est possible d'utiliser des architectures à deux cellules par bit logique, telles que celle illustrée sur la figure 2. L'état logique « 1 » ou « 0 » d'un bit, ou bit logique, est alors représenté par deux données binaires.

Le but de telles architectures est de conserver l'intégrité des données, si l'une des cellules-mémoire appairées est hors service. Avec de telles architectures il est possible de stocker deux fois une donnée binaire ou bien, comme illustré sur la figure 2, une donnée binaire dans l'une des cellules-mémoire et les données binaires complémentaires dans l'autre cellule-mémoire.

Plus précisément, un plan-mémoire PPM à deux cellules par bit comporte ici deux cellules-mémoire CEL1 et CEL2 comportant chacune un transistor de sélection de ligne de bit TSBL1, TSBL2 et un transistor à grille flottante TGF1, TGF2. Un seul transistor de sélection de grille de commande TSCG est prévu pour la commande des deux grilles de commande CG1 et CG2 des transistors TGF1 et TGF2.

Avec une telle architecture, un octet comporte donc typiquement 16 cellules-mémoire plus un transistor de sélection TSCG.

Afin de pouvoir programmer plus rapidement, par exemple de diviser par deux le temps de programmation, il est possible de prévoir un transistor de sélection de grille de commande individuel par cellule-mémoire, de façon à pouvoir individualiser l'effacement.

On peut ainsi effectuer simultanément l'effacement de certaines cellules et l'écriture des autres. Avec une telle architecture, un octet comporte donc 16 cellules-mémoire et 16 transistors de sélection. Par ailleurs, chaque cellule-mémoire doit comporter une ligne de masse dédiée, ce qui conduit à un total de 16 lignes de masse.

Une autre solution, permettant de combiner deux cellules par bit et l'effacement électrique et en simultané pourrait consister, dans le cas d'un octet, à reproduire huit fois l'architecture de la figure 2, ce qui conduit alors à obtenir 16 cellules-mémoire, huit transistors de sélection de grille de commande, et 8 lignes de masse car une ligne de masse est dédiée par paire de cellules.

Ainsi, quelle que soit l'option envisagée, stocker un mot numérique avec deux cellules par bit tout en pouvant effectuer un effacement et une écriture simultanément, est coûteuse en place.

Selon un mode de réalisation, il est par conséquent proposé un dispositif de mémoire permettant de combiner un stockage d'un bit sur deux cellules par bit, avec un effacement et une écriture simultanés de bits d'un mot numérique stocké, par exemple un octet, c'est-à-dire avec un seul cycle de programmation, et ce avec un gain de place important.

Selon un autre mode de réalisation, il est également proposé un dispositif de mémoire offrant un décodage colonne plus uniforme, plus simple et plus compact.

Ainsi, selon un aspect, il est proposé un dispositif de mémoire, comprenant au moins un plan-mémoire du type non volatile électriquement programmable et effaçable comportant deux cellules-mémoire respectivement connectées à deux lignes de bits par l'intermédiaire de deux transistors de sélection de lignes de bits.

Selon une caractéristique générale de cet aspect, la borne commune entre le transistor de sélection de ligne de bit et le transistor à grille flottante de chaque cellule-mémoire du plan-mémoire est connectée à la grille de commande du transistor à grille flottante de l'autre cellule-mémoire du plan-mémoire.

Ainsi, le transistor de sélection de ligne de bit d'une cellule-mémoire sert de transistor de sélection de grille de commande pour l'autre cellule-mémoire et inversement. On s'affranchit donc d'un transistor spécifique de sélection de grille de commande présent dans les architectures classiques de point-mémoire EEPROM.

Par ailleurs, la connexion entre ladite borne commune et la grille de commande du transistor à grille flottante de l'autre cellule-mémoire du plan-mémoire est avantageusement une connexion directe, c'est-à-dire sans élément intermédiaire.

Selon un mode de réalisation, on stocke dans un tel plan-mémoire une donnée binaire et la donnée binaire complémentaire, et les deux électrodes des deux transistors à grille flottante, par exemple leurs sources, opposées auxdites deux bornes communes, sont respectivement connectées à deux bornes distinctes de tension de référence, par exemple deux bornes de masse distinctes.

Selon un mode de réalisation, les deux cellules-mémoire sont disposées tête bêche, en vis-à-vis, les deux transistors à grille flottante étant mutuellement décalés de façon à éviter tout croisement entre les interconnexions internes du point-mémoire.

Selon un mode de réalisation, de façon à assurer d'une part, la continuité d'une ligne de mot réalisée en polysilicium, et d'autre part, la connexion entre le transistor d'état (le transistor à grille flottante) d'une cellule-mémoire et la ligne de masse correspondante, les deux électrodes des deux transistors à grille flottante, opposées auxdites deux bornes communes, sont respectivement connectées aux deux bornes de masse distinctes par l'intermédiaire de deux transistors auxiliaires ayant chacun sa source et son drain reliés, la grille d'un transistor auxiliaire associé à une cellule-mémoire étant connectée à la grille du transistor de sélection de ligne de bit de l'autre cellule-mémoire et vice-versa.

Selon un mode de réalisation, le dispositif comprend en outre un moyen formant mémoire-verrou (ou « verrou de programmation »), communément désigné par l'homme du métier sous la dénomination anglosaxonne de « latch », connecté aux deux lignes de bits, et possédant une structure totalement symétrique relativement aux deux lignes de bits.

En d'autres termes, une telle mémoire-verrou, totalement symétrique, gère les deux lignes de bits des cellules appairées. Et il n'est plus besoin de prévoir des mémoires-verrou dédiées à la commande des grilles de commande, qui sont présentes dans les architectures EEPROM classiques.

Selon un mode de réalisation, le dispositif comprend un plan-mémoire matriciel comportant plusieurs points-mémoire, toutes les lignes de bits étant formées par des premières lignes s'étendant selon une première direction, et les grilles des transistors de sélection de lignes de bits des points-mémoire sont reliées à des deuxièmes lignes, communément désignées sous le vocable de « lignes de mots », s'étendant selon une deuxième direction.

D'autres avantages et caractéristiques de l'invention apparaîtront à la description détaillée de modes de réalisation, nullement limitatifs, et des dessins annexés sur lesquels :
- les figures 1 et 2, déjà décrites, illustrent schématiquement des architectures classiques de points-mémoire EEPROM ;
- les figures 3 et 4 illustrent deux modes de réalisation d'un point-mémoire selon l'invention ;
- la figure 5 illustre un exemple de topologie (« layout », en langue anglaise), d'un plan-mémoire selon l'invention, et
- la figure 6 illustre schématiquement un mode de réalisation d'une mémoire-verrou de ligne de bits selon l'invention.

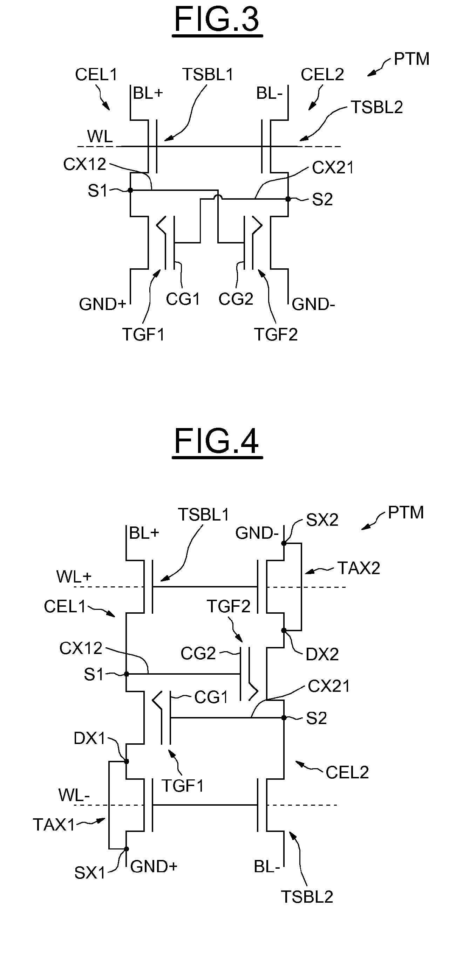

Sur la figure 3, la référence PTM désigne un point-mémoire du type EEPROM, différentiel, c'est-à-dire destiné à stocker une donnée binaire et son complément, et du type à deux cellules par bit.

Plus précisément, ce point-mémoire PTM comporte une première cellule-mémoire CEL1 et une deuxième cellule-mémoire CEL2.

La première cellule-mémoire CEL1 comporte un transistor d'état ou transistor à grille flottante TGF1 et un transistor de sélection de ligne de bit TSBL1, permettant de connecter la cellule CEL1 à la ligne de bits BL+.

De même, la deuxième cellule-mémoire CEL2 comporte un transistor d'état à grille flottante TGF2 connecté à la ligne de bits BL-par l'intermédiaire d'un transistor de sélection de ligne de bit TSBL2.

La source S1 du transistor de sélection de ligne de bit TSBL1 forme également le drain du transistor TGF1 et cette borne commune, référencée S1, est reliée à la grille de commande CG2 du transistor TGF2 par l'intermédiaire d'une interconnexion CX12.

De même, la borne commune S2 (source du transistor TSBL2 et drain du transistor TGF2) est connectée à la grille de commande CG1 du transistor TGF1 par une interconnexion CX21.

Puisque le point-mémoire est différentiel, les deux autres électrodes des deux transistors à grille flottante, en l'espèce leur source, sont respectivement connectées à deux bornes de masse distinctes GND+ et GND-.

Enfin, les grilles des deux transistors de sélection de lignes de bits TSBL1 et TSBL2 sont connectées à une ligne de mot WL.

On voit donc que, avec une telle architecture, le transistor de sélection de ligne de bit d'une cellule sert de transistor de sélection de grille de commande pour l'autre cellule et inversement.

Il en résulte donc un gain de place important.

Par ailleurs, si l'on suppose par exemple qu'un bit logique « 0 » programmé correspond à la programmation de deux données binaires (1,0), et qu'un bit logique « 1 » programmé correspond à la programmation de deux données binaires (0,1), on procède de la façon suivante pour écrire un bit logique « 0 » (ce qui correspond à l'effacement du point-mémoire) :
on laisse généralement flottante la ligne de bit BL-, on applique une tension de programmation Vpp sur la ligne de mot WL ainsi que sur la ligne de bit BL+ tandis qu'on applique une tension nulle sur la borne de masse GND- et qu'on laisse la borne de masse GND+ flottante.

Pour écrire un bit logique « 1 », on applique la tension de programmation Vpp sur la ligne de mot WL ainsi que sur la ligne de bit BL- tandis qu'on applique la tension nulle sur la ligne de bit BL+ et sur la borne de masse GND+ tout en laissant la borne de masse GND- flottante.

On voit donc qu'un point-mémoire peut recevoir un stimulus d'écriture ou d'effacement.

Ainsi, dans le cas d'un stockage d'un mot de plusieurs bits sur respectivement plusieurs points-mémoire PTM, on peut individualiser l'écriture et l'effacement des points-mémoire. En d'autres termes, on peut simultanément, c'est-à-dire au cours d'un seul cycle de programmation, programmer certains points-mémoire du mot et en effacer d'autres.

En lecture, les bornes de masse GND+ et GND- d'un point-mémoire PTM sont mises à la tension nulle.

Ainsi, le stockage d'un octet nécessite 16 cellules-mémoire incluant bien évidemment 16 transistors de sélection de lignes de bits mais aucun transistor spécifique supplémentaire de sélection de grille de commande.

Dans le mode de réalisation de la figure 4, les deux cellules-mémoire CEL1 et CEL2 sont disposées tête bêche, en vis-à-vis, et les deux transistors à grille flottante TGF1 et TGF2 sont mutuellement décalés de façon à éviter tout croisement entre les interconnexions internes CX12 et CX21 du point-mémoire PTM.

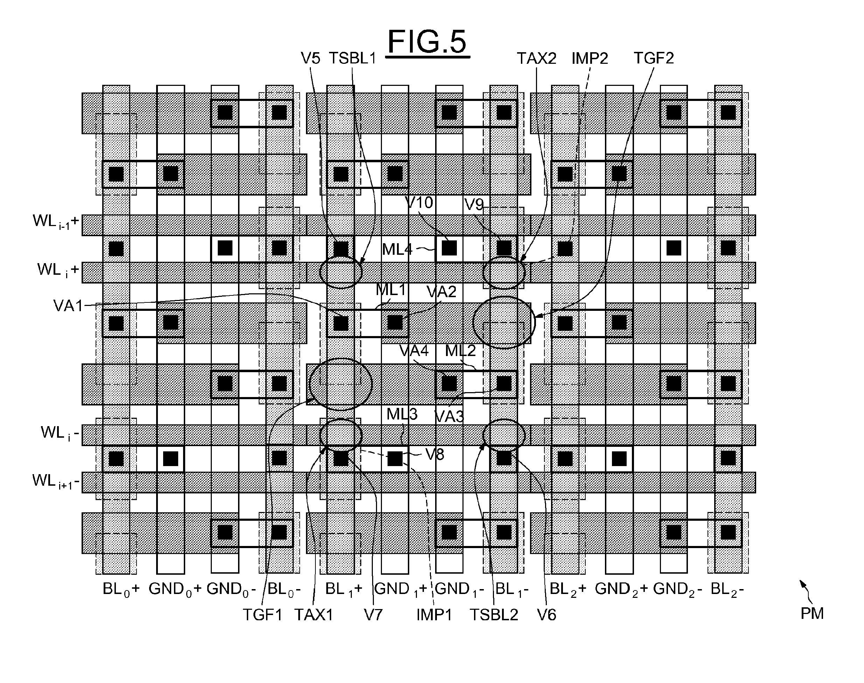

Ceci permet une réalisation plus aisée de la topologie (« layout ») d'un plan-mémoire PM dont un exemple de représentation est illustré sur la figure 5.

Sur cette topologie, le plan-mémoire PM comporte des lignes horizontales de polysilicium formant des lignes de mots WLᵢ+, WLᵢ-, ainsi que des métallisations verticales formant les lignes de bits BLⱼ+ et BLⱼ-.

On suppose dans cet exemple que le point-mémoire PTM de la figure 4 est celui qui se trouve à l'intersection des lignes de mots WLᵢ+, WLᵢ- et des lignes de bits BL₁+ et BL₁-.

On voit ainsi qu'en raison de la disposition tête bêche légèrement décalée des cellules-mémoire, la borne commune S1 (source du transistor TSBL1 et drain du transistor TGF1) est aisément connectée à la grille de commande du transistor TGF2 par l'intermédiaire de deux contacts VA1 et VA2 mutuellement reliés par une métallisation ML1 située ici au niveau de métal 1.

De même, la borne commune entre le transistor TGF2 et le transistor TSBL2 est connectée à la grille de commande du transistor TGF1 par l'intermédiaire de deux contacts VA3 et VA4 mutuellement connectés par une métallisation ML2 également située au niveau de métal 1.

Par ailleurs, de façon à assurer la continuité des lignes de mots en polysilicium WLᵢ + et WLᵢ-, ainsi que la connexion entre le transistor à grille flottante correspondant et la ligne de masse GND₁+ et GND₁-, il est prévu (figure 4) que les deux électrodes des deux transistors à grille flottante TGF1 et TGF2, opposées auxdites bornes communes S1 et S2, soient respectivement connectées aux deux bornes de masse GND+ et GND- par l'intermédiaire de deux transistors auxiliaires TAX1 et TAX2 ayant chacun sa source SX1, SX2, et son drain DX1, DX2 respectivement reliés.

Par ailleurs, la grille d'un transistor auxiliaire associée à une cellule-mémoire est connectée à la grille du transistor de sélection de ligne de bit de l'autre cellule-mémoire et vice-versa.

On voit sur la figure 5 que la mise en court-circuit de la source SX1 du transistor auxiliaire TAX1 avec son drain DX1 est réalisée par une implantation semiconductrice spécifique IMP1 dans le substrat semiconducteur.

Il en est de même pour l'implantation spécifique IMP2 réalisée dans le substrat qui permet de court-circuiter la source SX2 et le drain DX2 du transistor auxiliaire TAX2.

Par ailleurs, la source SX1 du transistor TAX1 est reliée à la ligne de masse GND₁+ par l'intermédiaire d'un contact V7 et d'un via V8 reliés par une métallisation ML3 située au niveau du métal 1.

De même, la source SX2 du transistor TAX2 est reliée à la ligne de masse dédiée GND₁- par l'intermédiaire d'un contact V9 et d'un via V10 reliés par une métallisation ML4 également située au niveau du métal 1.

Les lignes de masse GND₁+ et GND₁- sont en effet ici des métallisations situées au niveau de métal 2.

Enfin, le drain du transistor de sélection de ligne de bit TSBL1 est relié à la ligne de bits BL₁+ située au niveau de métal 2 par une connexion V5 comportant un contact, une portion de métallisation située au niveau de métal 1 et un via, tandis que le drain du transistor TSBL2 est relié à la ligne de bits BL₁- située au niveau de métal 2 par une connexion V6 comportant un contact, une portion de métallisation située au niveau de métal 1 et un via.

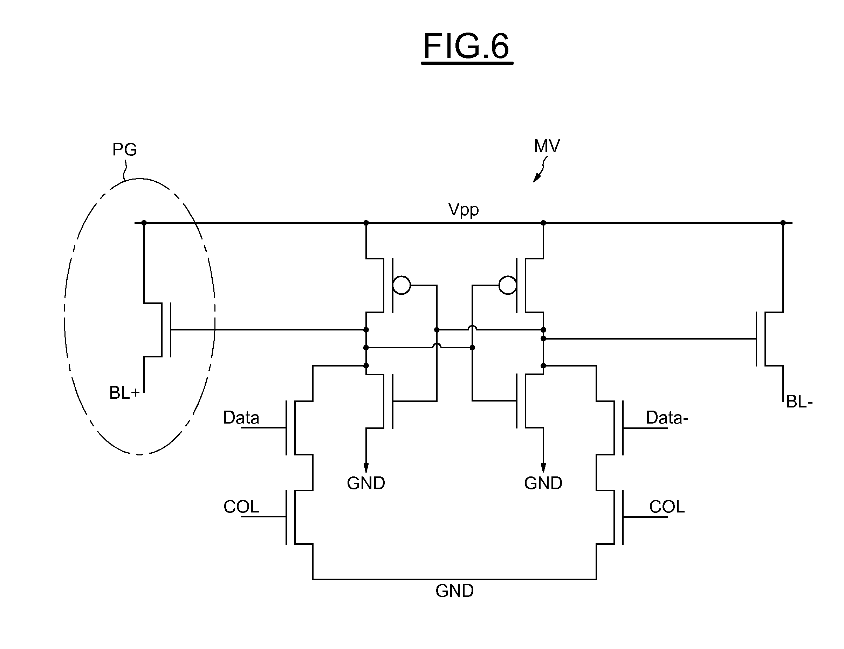

De façon classique, chaque ligne de bit de chaque colonne est relié à une ligne de programmation commune par l'intermédiaire d'un verrou de programmation MV (figure 6) communément désigné par l'homme du métier sous la dénomination anglosaxonne de « latch ». Chaque verrou de programmation MV possède deux entrées Data et Data- pour recevoir les données binaires devant être enregistrées dans un point-mémoire, ainsi qu'un signal de sélection de colonne COL.

La partie du milieu et la partie droite de la figure 6 illustrent une architecture classique de verrou MV. La partie gauche, PG, qui est entourée, illustre une modification du verrou selon l'invention. On voit donc que la partie gauche PG, qui comporte un transistor reliant la tension de programmation Vpp à la ligne de bits BL+ par l'intermédiaire d'un transistor, est strictement identique à la partie droite du verrou.

L'architecture de ce verrou MV est donc parfaitement symétrique relativement aux deux lignes de bits BL+ et BL-.

Sa structure est considérablement simplifiée par rapport à une structure de l'art antérieur et les mémoires-verrou spécifiquement associées aux transistors de sélection de grille de commande des architectures de points-mémoire classiques n'existent plus puisque ces transistors spécifiques de sélection de grille de commande n'existent plus dans les points-mémoire selon l'invention.

## Revendications

1. Dispositif de mémoire, comprenant au moins un point mémoire (PTM) du type non volatile électriquement programmable et effaçable comportant deux cellules mémoire (CEL1, CEL2) respectivement connectées à deux lignes de bits (BL+, BL-) par l'intermédiaire de deux transistors de sélection de lignes de bits, **caractérisé en ce que** la borne commune (S1) entre le transistor de sélection de ligne de bit (TSBL1) et le transistor à grille flottante (TGF1) de chaque cellule-mémoire (CEL1) du point-mémoire est connectée à la grille de commande (CG2) du transistor à grille flottante (TGF2) de l'autre cellule-mémoire (CEL2) du point-mémoire.

2. Dispositif selon la revendication 1, dans lequel les deux électrodes des deux transistors à grille flottante, opposées auxdites deux bornes communes (S1, S2) sont respectivement connectées à deux bornes distinctes de tension de référence (GND+, GND-).

3. Dispositif selon la revendication 1 ou 2, dans lequel les deux cellules-mémoires (CEL1, CEL2) sont disposées tête-bêche, en vis-à-vis, les deux transistors à grille flottante (TGF1, TGF2) étant mutuellement décalés de façon à éviter tout croisement entre les interconnexions internes (CX12, CX21) du point mémoire.

4. Dispositif selon les revendications 2 et 3, dans lequel les deux électrodes des deux transistors à grille flottante, opposées auxdites deux bornes communes (S1, S2), sont respectivement connectées aux deux bornes distinctes de tension de référence par l'intermédiaire de deux transistors auxiliaires (TAXI, TAX2) ayant chacun sa source et son drain reliés, la grille d'un transistor auxiliaire associé à une cellule-mémoire étant connectée à la grille du transistor de sélection de ligne de bit de l'autre cellule-mémoire, et vice-versa.

5. Dispositif selon l'une des revendications précédentes, comprenant en outre un moyen formant mémoire-verrou (MV) connecté aux deux lignes de bits et possédant une structure totalement symétrique relativement aux deux lignes de bits.

6. Dispositif selon l'une des revendications précédentes, comprenant un plan mémoire matriciel (PM) comportant plusieurs points-mémoires, toutes les lignes de bits (BLⱼ+, BLⱼ-) étant formées par des premières lignes s'étendant selon une première direction et les grilles des transistors de sélection de lignes de bits des points-mémoire étant reliés à des deuxièmes lignes (WLᵢ+, WLᵢ-) s'étendant selon une deuxième direction.
